# EUROPÄISCHE PATENTANMELDUNG

(11) **EP 0 525 374 A1**
(43) Veröffentlichungstag der Anmeldung: **03.02.1993**
(21) Anmeldenummer: 92110446.9
(22) Anmeldetag: 20.06.1992
(51) Int. Cl.: H03K 17/96, H01H 3/12

(54) **Piezoelektrischer Taster**

(30) Priorität: 25.07.1991 DE 4124604
(71) Anmelder: Ing. Wolfgang Schäfer GmbH Elektrotechnik + Maschinenbau, D-72488 Sigmaringen (DE)
(72) Erfinder: Schäfer, Wolfgang, W-7480 Sigmaringen-Laiz (DE); Scholz, Marina, W-7481 Bingen (DE)
(74) Vertreter: Rüger, Rudolf, Dr.-Ing.

(57) **Zusammenfassung**

Ein piezoelektrischer Taster (1) weist ein Gehäuse (2) auf, das eine von seiner Frontseite ausgehende Ausnehmung (7) enthält. In der Ausnehmung (7) befinden sich gestapelt übereinander ein scheibenförmiges Ausgleichsstück (17) aus Gummi, ein darauf befestigtes scheibenförmiges, piezokeramisches Element (24), ein ringförmiges Distanzstück (27) sowie eine Betätigungsplatte (29). Alle diese Elemente sind flächig miteinander verklebt.

Die Öffnung (8) der Ausnehmung (7) hat eine Außenkontur entsprechend der Außenkontur der Bestätigungsplatte (29), die im nichtbetätigten Zustand mit der Fläche der Frontseite des Gehäuses bündig ist. An der Rückseite der Betätigungsplatte ragen Fortsätze (9) in die Ausnehmung (7), die den Hub der Betätigungsplatte (24) begrenzen.

Der piezoelektrische Taster (1) ist weitgehend vandalensicher und erfordert zur Führung der Betätigungsplatte (29) keine Führungselemente.

## Beschreibung

Die Erfindung betrifft einen piezoelektrischen Taster mit den Merkmalen des Oberbegriffs des Anspruches 1.

Aus der DE-OS 32 26 350 ist ein gattungsgemäßer piezoelektrischer Taster bekannt, dessen aktives Element eine piezoelektrisch wirksame Keramikplatte ist. Der bekannte Taster enthält ein in der Seitenansicht etwa U-förmiges Gehäuse, das von einer Bodenplatte und zwei seitlich der Bodenplatte aufragenden Schenkeln gebildet ist. Die Bodenplatte trägt neben den Schenkeln zwei parallel mit Abstand zueinander verlaufende Leisten, die einen Sitz für die piezokeramische Platte bilden. Oberhalb der Platte ist jeder der beiden Schenkel mit einer parallel zu der Ebene der Bodenplatte verlaufenden Nut versehen.

Beide Nuten liegen auf gleicher Höhe und dienen der Halterung einer Rückstellfeder, auf der das Betätigungsorgan aufsitzt. Zum Betätigen des Tasters wird das Betätigungsorgan entgegen der Wirkung der zwischen den Schenkeln des Gehäuses gehaltenen Blattfeder auf das piezokeramische Element niedergedrückt, das dadurch zwischen den beiden Leisten auf Biegung beansprucht wird.

Um eine übermäßige Durchbiegung des piezokeramischen Elementes zu vermeiden, befindet sich auf der Bodenplatte dem Betätigungsorgan gegenüber eine weitere Leiste, um einen Bruch des piezokeramischen Elementes zu verhindern.

Der bekannte Schalter erfordert einen verhältnismäßig langen Betätigungshub, denn im nichtbetätigten Zustand steht das Betätigungsorgan in einem erheblichen Abstand von dem piezokeramischen Element. Große Betätigungswege bringen jedoch bei der praktischen Ausführung Probleme hinsichtlich der Führung bzw. der Verschmutzung der Führungen in rauher Umgebung mit sich.

Außerdem ist es schwierig, Schalter oder Taster mit langem Betätigungshub hinreichend vandalensicher zu bauen.

Ausgehend hiervon ist es Aufgabe der Erfindung, einen piezoelektrischen Taster zu schaffen, der gegen mutwillige mechanische Zerstörung von außen mit Hilfe einfacher Werkzeuge geschützt ist.

Diese Aufgabe wird erfindungsgemäß durch den piezoelektrischen Taster mit den Merkmalen des Anspruches 1 oder 2 gelöst.

Infolge des speziellen Aufbaues des neuen piezoelektrischen Tasters ergibt das Betätigungsorgan in Gestalt der stabilen Platte einen hinreichenden mechanischen Schutz für die dahinter liegenden empfindlichen elektrischen Teile. Außerdem führt der sandwichartige Aufbau der einzelnen Teile des Schalters zwischen dem als Platte ausgebildeten Betätigungsorgan und dem Sitz zu einem sehr kurzen Betätigungshub, insbesondere dann, wenn die einzelnen Teile mit den aneinander angrenzenden Flächen unmittelbar aufeinanderliegen. Schließlich gestattet die neue Lösung den Aufbau eines neuen Tasters mit verhältnismäßig geringer Tiefe, weil zwischen dem Sitz und dem Betätigungsorgan nur flache, scheibenförmige Bauelemente enthalten sind. Eine getrennte Führungseinrichtung für das Betätigungsorgan ist nicht erforderlich.

Eine robuste und gleichzeitig platzsparende Anordnung wird erhalten, wenn das piezokeramische Element aus einer piezoelektrisch wirkenden Keramikscheibe sowie einer mit der Keramikscheibe stoffschlüssig verbundenen Metallscheibe besteht, die randseitig über die Keramikscheibe übersteht. Dabei ist es besonders zweckmäßig, wenn das Element kreisförmig ist, weil dadurch eine gleichmäßige Kräfteverteilung ohne allzu große Spannungsspitzen beim Verbiegen des Elementes möglich ist.

Ein einfach herzustellender und robuster Aufbau entsteht, wenn das piezokeramische Element an einem Distanzstück oder einer Distanzscheibe angeordnet ist, die als Ring ausgeführt ist, dessen Mittenöffnung gleich dem Durchmesser der eigentlichen Keramikscheibe ist. Beim Zusammendrükken wird von dem Distanzstück das piezokeramische Element verbogen, wozu einerseits nur geringe Kräfte erforderlich sind, andererseits aber große Kräfte das Element auch nicht zu beschädigen vermögen. Ein weitergehender Schutz gegen Beschädigungen ergibt sich aufgrund des Zusammenwirkens des Betätigungsorgans mit dem in die Öffnung des Gehäuses hineinragenden Fortsätzen. Sobald das Betätigungsorgan mit seiner Rückseite auf die Fortsätze aufstößt, ist eine weitere Krafteinleitung in das piezokeramische Element unmöglich. Die dabei maximal auftretende Kraft ist durch das nachgiebige Zwischenelement oder Zwischenstück festgelegt.

Es versteht sich, daß das Distanzstück ebenfalls eine gewisse Nachgiebigkeit aufweist, um die Verformung des piezokeramischen Elementes zu ermöglichen.

Das Distanzstück besteht deswegen vorzugsweise aus einer Kunststoffscheibe.

Der platzsparende sandwichartige Aufbau wird erhalten, indem die einzelnen Elemente, beispielsweise durch Kleben, stoffschlüssig miteinander verbunden sind.

Da bei dem neuen Taster die Höhe des Paketes, bestehend aus dem piezokeramischen Element, dem Distanzstück und dem nachgiebigen Zwischenstück gering ist gegenüber dem Durchmesser dieses Paketes an der schwächsten Stelle, ergibt sich eine sehr große Festigkeit in Richtung quer zum Betätigungsweg. Ein seitliches Verdrükken des plattenförmigen Betätigungsorgangs ist deswegen weitgehend ausgeschlossen und es können dadurch auch keine Beschädigungen an dem piezoelektrisch wirksamen Teil, nämlich der Keramikscheibe, hervorgerufen werden.

Wenn das plattenförmige Betätigungsorgan mit der Frontseite des Gehäuses des Tasters bündig ist, ergeben sich fast keine Angriffsmöglichkeiten für Werkzeuge, um das Betätigungsorgan aus dem Gehäuse herauszuheben. Der erforderliche seitliche Spalt kann wegen der Stabilität des dahinter befindlichen paketförmigen Stapels sehr klein gemacht werden, ohne daß die Gefahr besteht, daß das Betätigungsorgan am Rand der Öffnung streift. Spaltweiten von herunter bis zu einem Zehntel Millimeter sind ohne weiteres möglich.

Bei einer anderen Ausführungsform kann die Betätigungsplatte mit dem Gehäuse einstückig sein, was einen absolut dichten Aufbau ergibt.

In der Zeichnung sind Ausführungsbeispiele des Gegenstandes der Erfindung dargestellt. Es zeigen:
Fig. 1 einen neuen piezoelektrischen Taster in einer perspektivischen Explosionsdarstellung,
Fig. 2 die Verformung des piezokeramischen Elementes bei einer Betätigung des Tasters in stark übertriebener Darstellung in einer Seitenansicht und
Fig. 3 ein weiteres Ausführungsbeispiel des neuen piezoelektrischen Tasters in einem Querschnitt.

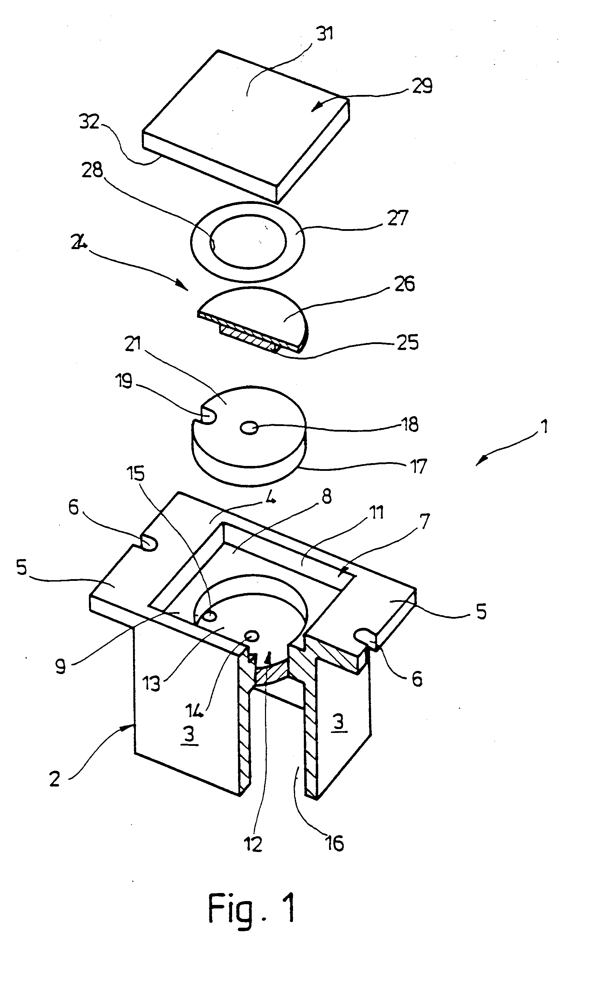

Gemäß Fig. 1 weist ein piezoelektrischer Taster 1 ein etwa quaderförmiges Gehäuse 2 mit Seitenwänden 3 und einer zu den Seitenwänden 3 rechtwinklig verlaufenden Frontseite 4 auf. Die Seitenwände 3 verlaufen paarweise einander gegenüberstehend parallel, wobei jeweils zwei an einer Ecke aneinanderstoßende Seitenwände 3 rechtwinklig zueinander sind. Im Bereich der Frontseite 4 sind an das Gehäuse 2 an zwei einander gegenüberliegenden Seitenwänden 3 nach außen wegstehende Befestigungsflansche 5 angeformt, die bündig in die Frontseite 4 übergehen und randseitige Befestigungsöffnungen 6 enthalten.

Das Gehäuse 2 enthält eine von der Frontseite 4 ausgehende rechteckige Ausnehmung 7, die in der Frontseite 4 eine Öffnung 8 bildet und im Abstand von einer durch die Frontseite 4 definierten Ebene von einem ebenen Boden 9 begrenzt ist. Die rechteckige Öffnung 8 ist auf diese Weise von vier auf dem Boden 9 senkrecht stehenden schmalen Wänden 11 begrenzt.

In dem ebenen Boden 9 befindet sich eine weitere Ausnehmung 12, die jedoch kreisförmigen Querschnitt hat und deren Durchmesser kleiner ist als die kleinste Erstreckung des Bodens 9, gemessen zwischen den Wänden 11. Auch die Ausnehmung 12 ist von einem ebenen Boden 13 begrenzt, der zwei Durchgangsöffnungen 14 und 15 enthält. Von diesen ist die Durchgangsöffnung 14 konzentrisch in der Mitte der Ausnehmung 12 angebracht, während sich die Öffnung 15 in der Nähe der seitlichen Wand der Ausnehmung 12 befindet.

Bezogen auf Fig. 1 befindet sich unterhalb der kreisförmigen Ausnehmung 12 eine von den Seitenwänden 3 begrenzte und zur Unterseite des Gehäuses 2 hin offene Kammer 16, die lediglich über die Durchgangsöffnungen 14 und 15 mit der Ausnehmung 12 in Verbindung steht.

Der Boden 13 bildet einen Sitz für eine kreisförmige, verglichen mit den nachfolgend beschriebenen Elementen dicke Gummischeibe 17, deren Durchmesser etwa dem Durchmesser der Ausnehmung 12 entspricht. Sie enthält eine mittige, mit der Durchgangsöffnung 14 fluchtende Öffnung 18 sowie randseitig einen mit der Durchgangsöffnung 15 fluchtenden Schlitz 19 und ist mit dem Boden 13 stoffschlüssig, beispielsweise durch Kleben, unlösbar verbunden. Auf ihrer von dem Boden 13 wegweisenden planen Oberseite 21 ist ein keramisches piezokeramisches Element aufgeklebt. Das piezokeramische Element besteht aus einer piezoelektrisch wirksamen keramischen Scheibe 25, die stoffschlüssig, leitend und konzentrisch mit einer beispielsweise aus Messing bestehenden kreisförmigen Scheibe 26 verbunden ist. Der Durchmesser der Keramikscheibe 25 ist kleiner als der Durchmesser der Metallscheibe 26, so daß diese über die Keramikscheibe 25 übersteht. Der Durchmesser der metallischen Scheibe 26 ist etwa gleich dem Durchmesser der Gummischeibe 17 und in jedem Falle kleiner als der lichte Innendurchmesser der zylindrischen Ausnehmung 12.

Die metallische Scheibe 26 trägt auf ihrer von der Keramikscheibe 25 abliegenden Seite eine ringförmige Scheibe 27 geringer Dicke, ca. 0,1 mm, wobei ihre Mittenöffnung 28 einen Durchmesser hat, der gleich oder größer wie der Durchmesser der Keramikscheibe 25 ist. Die ringförmige Scheibe 27 ist wiederum auf die metallische Scheibe 26 aufgeklebt und stellt die mechanische Verbindung mit einem Betätigungsorgan 29 her, das als verhältnismäßig dicke, planparallele Platte mit einer Vorderseite 31 sowie einer Rückseite 32 ausgebildet ist. Die Außenkontur dieser Betätigungsplatte 29 entspricht der lichten Weite der Öffnung 8, so daß die Betätigungsplatte 29 mit geringem seitlichen Spiel in der Ausnehmung 11 Platz finden kann.

Im montierten Zustand bilden die Gummischeibe 17, die als Distanzstück wirkende kleine Scheibe 22, das piezokeramische Element 24 sowie die ebenfalls als Distanzstück wirkende ringförmige Scheibe 27 einen sandwichartig aufgebauten Stapel, der konzentrisch in der kreisförmigen Ausnehmung 12 befestigt ist und fest auf deren Boden 13 festgeklebt ist. Dabei fluchten die Mittenöffnung 23 und die Mittenöffnung 18 miteinander sowie mit der Durchgangsöffnung 14 und der seitliche Schlitz 19 mit der Durchgangsöffnung 15.

Das Verkleben kann durch doppelseitig klebende Klebefolien erfolgen und auch das Distanzstück 27 kann von einer Klebefolie gebildet sein.

Die Tiefe der kreiszylindrischen Ausnehmung 12 ist etwas kleiner als der eben erwähnte Stapel, so daß die Oberseite der ringförmigen Scheibe 27 sich um die Höhe des erforderlichen Betätigungshubes über die von dem planen Boden 9 definierte Ebene erhebt. Die Tiefe der rechteckigen Ausnehmung 7 zuzüglich der Tiefe der kreiszylindrischen Ausnehmung 12 ist dagegen so bemessen, daß die Betätigungsplatte 29, die mit ihrer Rückseite 32 auf die ringförmige Scheibe 27 aufgeklebt ist, mit ihrer Vorderseite 31 mit der Frontseite 4 des Gehäuses 2 bündig ist. Die Rückseite 32 der Betätigungsplatte 29 verläuft dabei in einem geringfügigen Abstand zu dem ebenen Boden 9; der Abstand ist geringfügig größer als der Betätigungshub. Mit anderen Worten, der ebene Boden 9 bildet einen Vorsprung bzw. eine Ringschulter, die nach innen zu vorspringt und einen Anschlag darstellt, an den sich die Rückseite 32 der Betätigungsplatte 29 anlegen kann, um ein weiteres Eindringen der Betätigungsplatte 29 in das Gehäuse 2 zu begrenzen.

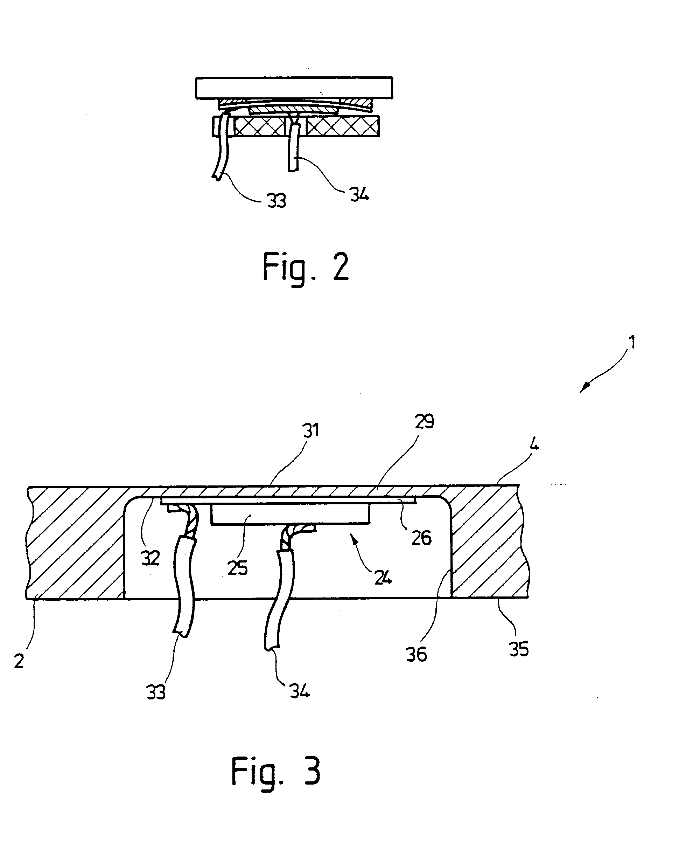

Zur elektrischen Kontaktierung des piezokeramischen Elementes 24 sind zwei elektrische Anschlußlitzen 33 und 34 vorhanden (siehe Fig. 2). Die Anschlußlitze 33 führt durch die Durchgangsöffnung 15 sowie den Schlitz 19 und ist an der Unterseite der metallischen Scheibe 26 im Bereich von deren Überstand über die Keramikscheibe 25 angelötet oder sonstwie elektrisch leitend befestigt. Die andere Anschlußlitze 34 führt durch die Durchgangsöffnung 19 sowie die Mittenöffnung 18 zu der Unterseite der Keramikscheibe 25, an der auch diese Anschlußlitze 34 elektrisch leitend angeschlossen ist.

In der Ruhestellung des gezeigten piezoelektrischen Tasters 1 sind das piezokeramische Element 24 sowie die Gummischeibe 17, die in weiter unten beschriebener Weise als Zwischen- oder Ausgleichsstück wirkt, in ihrer unverformten Ruhestellung. In dieser Stellung ist, wie bereits erwähnt, die Vorderseite 21 der Betätigungsplatte 21 mit der Frontseite 4 bündig. Der zwischen den Seitenwänden 11 und der quaderförmigen Betätigungsplatte 29 begrenzte Spalt hat nur eine geringe Weite, beispielsweise ein Zehntel Millimeter. Diese Spaltweite reicht ohne weiteres aus, um ein sicheres Betätigen zu ermöglichen, da der auf dem Boden 13 aufgeklebte Stapel aus Distanzstücken und dem piezokeramischen Element 24 eine Höhe hat, die deutlich kleiner ist als der Durchesser dieses Stapels an der schwächsten Stelle, beispielsweise im Bereich der Keramikscheibe 25. Dadurch ist ein seitliches Verdrücken der Betätigungsplatte 25 bis zur Anlage an eine der Randflächen 11 praktisch ausgeschlossen. Bei Gewaltanwendung legt sich die Betätigungsplatte 29 wegen des geringen seitlichen Spaltes an die entsprechende Randseite 11 an, ehe es zu einer Beschädigung des piezokeramischen Elemente 24 oder der anderen damit verbundenen Teile kommt, und zwar durch Verformung der Gummischeibe 17.

Zur Betätigung des piezoelektrischen Tasters 1 wird die Betätigungsplatte 29 in Richtung auf den Boden 9 der Ausnehmung 7 gedrückt. Die hierbei aufgewendete Kraft wird von der ringförmigen Scheibe 27 auf den Randbereich der metallischen Scheibe 26 übertragen. Dieser Randberich liegt außerhalb der Projektionsfläche der Keramikscheibe 25 auf die metallische Scheibe 26. Da die Keramikscheibe 25 an ihrer Unterseite über die Gummischeibe 17 zu dem Boden 13 hin abgestützt ist, führt die randseitige Belastung des piezokeramischen Elementes 24 zu einer geringfügigen glokkenartigen Verbiebung, wie dies in Fig. 2 übertrieben dargestellt ist. Die Oberseite der metallischen Scheibe 26 wölbt sich dabei entsprechend in die große Öffnung 28 der ringförmigen Scheibe 27 vor. Ein vorzeitiges Aufstoßen des Randes der metallischen Scheibe 26 auf die Gummischeibe 17 verhindert die keramische Scheibe 25 .

Die so erzeugte Verbiegung des piezokeramischen Elementes 24 läßt an der Keramikscheibe 25 eine flüchtige Spannung entstehen, die über die beiden Anschlußlitzen 33 und 34 einer nicht weiter gezeigten elektronischen Schaltung zugeführt wird.

Bei einer normalen Betätigung gibt das piezokeramische Element 24 die notwendige Spannung ab, ehe die Rückseite 32 der Betätigungsplatte 29 auf dem Boden 9 aufstößt. Hierdurch ist im Normalbetrieb eine einwandfreie Funktion des piezoelektrischen Tasters gewährleistet. Sollte im Falle von Vandalismus eine über das notwendige Maß hinausgehende Kraft auf die Betätigungsplatte 29 einwirken, schreitet einerseits die Verformung des piezokeramischen Elementes 24 fort und andererseits kommt es zu einem zunehmenden Eindrükken der Keramikscheibe 25 in die Gummischeibe 17, deren Härte so ausgewählt ist, daß einerseites die erforderliche Verformung des piezokeramischen Elementes 24 möglich ist, andererseits aber ein elastisches Wegtauchen des piezokeramischen Elementes 24 in die Ausnehmung 12 erfolgen kann. Wenn die Verformung der Gummischeibe 17 weit genug fortgeschritten ist, legt sich die Rückseite 32 der Betätigungsplatte 29 auf dem Boden 9 auf. Hierdurch wird ein weiteres Hineinbewegen der Betätigungsplatte 29 in das Gehäuse 2 auch beim Auftreten sehr hoher Kräfte begrenzt. Die Betätigungsplatte 29 liegt wegen der symmetrischen Anordnung der Ausnehmung 12 innerhalb des Bodens 9 längs ihres gesamten Randes satt auf und nur der verhältnismäßig kleine, dem Durchmesser der Öffnung 12 entsprechende Bereich liegt hohl.

Ersichtlicherweise liefert die Gummischeibe 17 den erforderlichen Längenausgleich zwischen normaler und extremer Betätigung der Betätigungsplatte 29. Gleichzeitig wird hierdurch die maximal auf das piezokeramische Element 24 einwirkende Kraft auf ein Maß begrenzt, das die Keramikscheibe 25 noch nicht gewährdet.

Da Gummi im wesentlichen inkompressibel ist, ist der Durchmesser der Gummischeibe 17 etwas kleiner als die lichte Weite der Ausnehmung 12, damit sich die Gummischeibe 17 seitlich ausdehnen kann.

Außerdem hat die Verwendung der Gummischeibe 17 den Vorteil, daß Fertigungstoleranzen, die wegen der geringen Höhe des zwischen dem Boden 13 und der Rückseite 32 befindlichen Stapels einen großen Einfluß auf den Abstand der Rückseite 32 von dem Boden 9 haben, nur geringen Einfluß auf die Funktion des Tasters im Normal- bzw. im mechanischen Überlastungszustand haben. Gleichzeitig baut die Anordnung nicht sehr tief und es bleibt an der Rückseite des Gehäuses 2 genügend Raum zur Unterbringung der das elektrische Signal auswertenden Elektronik.

Wie sich aus der Erläuterung des Ausführungsbeispiels unschwer ergibt, kann die rechteckig veranschaulichte Betätigungsplatte 29 auch quadratisch, rund oder sonstwie konturiert sein, wobei dann die Kontur der Ausnehmung 7 entsprechend gestaltet ist.

Auch ist es grundsätzlich möglich, die Gummischeibe 17 zwischen dem ringförmigen Distanzstück 27 und der Betätigungsplatte 29 vorzusehen und die Keramikscheibe mit elastischem Kleber auf den als Sitz dienenden Boden 13 aufzukleben.

Die erläuterte Anordnung gibt auch dann mit Sicherheit ein ausreichendes elektrisches Signal an die nachfolgende Schaltung ab, wenn die Betätigung des Tasters 1 durch Niederdrücken der Betätigungsplatte 29 in der Nähe ihrer Ecken erfolgt. Es ist keineswegs notwendig, die Betätigung unmittelbar in der Mitte der Betätigungsplatte 29 vorzunehmen, um das elektrische Signal zu erzeugen.

In Fig. 3 ist ein weiteres Ausführungsbeispiel des neuen piezoelektrischen Tasters 1 veranschaulicht. Soweit dort gleiche Bauelemente verwendet sind, sind diese mit den Bezugszeichen aus dem vorangegangenen Ausführungsbeispiel versehen.

Das Gehäuse 2 des piezoelektrischen Tasters 1 nach Fig. 3 besteht aus einer ca. 10 mm starken Metallplatte, die an derjenigen Stelle, an der sich der eigentliche Taster befinden soll, mit einer von ihrer Rückseite 35 eingearbeiteten Ausnehmung 36 versehen ist. Die Ausnehmung hat kreiszylindrische Form und reicht bis dicht an die Frontseite 4 heran, so daß eine Stelle mit verjüngter Materialstärke entsteht, die die Betätigungsplatte 29 bildet. Die Betätigungsplatte 29 geht aufgrund der Herstellung einstückig in den Rest der Frontseite 4 über. Sie bildet, wie vorher, eine plane Vorderseite 31 sowie eine plane Rückseite 32. Auf der planen Rückseite 32 ist unmittelbar mit einem Klebstoff und somit stoffschlüssig das piezokeramische Element 24 mit seiner Metallscheibe 26 aufgeklebt. Die Keramikscheibe 25 zeigt somit von der Betätigungsplatte 29 weg.

Wie vorher, sind an die Mitte der Keramikplatte 25 sowie den nach außen über die Keramikplatte 25 überstehenden Rand der Metallscheibe 26 die beiden elektrischen Anschlußlitzen 33 und 34 angelötet oder angebondet.

Der piezoelektrische Taster 1 nach Fig. 3 arbeitet wie folgt: Bei einem Druck auf die Betätigungsplatte 29 wird diese geringfügig nach innen in die Ausnehmung 36 kalotten- oder glockenförmig verformt. Die Verformung überträgt sich auf das unmittelbar auf der Rückseite 32 aufgeklebt piezokeramische Element 24, das dadurch eine transiente Spannung über die Anschlußleitungen 33 und 34 an die nachfolgende elektronische Schaltung abgibt.

Da zum Erzeugen einer ausreichenden Spannung nur eine sehr geringe Durchbiegung des piezokeramischen Elementes 24 erforderlich ist, genügt auch bei der einstückigen Ausführungsform der Betätigungsplatte 29 mit dem Rest des Gehäuses 4 eine geringe Betätigungskraft.

Selbst wenn durch Schläge die Betätigungsplatte 29 über dem piezokeramischen Element 24 bleibend verformt sein sollte, bleibt die Funktionsfähigkeit des neuen Tasters 1 erhalten. Kurze Zeit nach der bleibenden Verformung der Betätigungsplatte 29 verschwindet die von dem piezokeramischen Element 24 abgegebene Spannung. Das piezokeramische Element 24 hat nun eine bleibende Vorverformung aufgrund der festen Verbindung mit der Betätigungsplatte 29. Wird durch Druck auf die Betätigungsplatte 29 die Verformung geändert, gibt das piezokeramische Element 24 gleichwohl wiederum eine Spannung ab.

Bei einer anderen nicht gezeigten Ausführungsform kann die Betätigungsplatte 29 von Feldern einer durchgehenden Blechplatte, beispielsweise aus Edelstahl gebildet sein, während die Ausnehmungen 36 entsprechende Öffnungen in einer gitterartigen Metallstruktur sind, auf deren Außenseite die Blechplatte unlösbar stoffschlüssig aufgesetzt ist.

Sowohl bei der in Fig. 3 gezeigten Ausführungsform als auch bei der Ausführungsform aus der Gitterstruktur und der aufgesetzten Blechplatte können Tastenfelder erzeugt werden, bei denen in einem großen flachen Gehäuse nebeneinander mehrere piezokeramische Taster 1, die gemäß Fig. 3 aufgebaut sind, angeordnet sind. Es muß nur dafür gesorgt sein, daß der Mittenabstand zwischen benachbarten piezokeramischen Tastern 1 groß genug ist, damit die Verformung einer Betätigungsplatte 29 sich nicht auf einen benachbarten piezokeramischen Taster 1 überträgt.

Die einstückige Ausführungsform kommt ebenfalls ohne besondere Führungseinrichtungen aus und hat obendrein den Vorteil, daß die Frontseite 4 absolut dicht ist.

In Fig. 3 ist die Klebstoffschicht, die sich zwischen der Metallscheibe 26 und der Rückseite 32 der Betätigungsplatte 29 befindet, nicht gezeigt. Sie hat eine verschwindend geringe Stärke, reicht aber aus, um die Metallscheibe 26 bei Bedarf elektrisch gegenüber der Betätigungsplatte 29 und damit dem Gehäuse 2 zu isolieren.

Abgesehen von einer Kombination aus Edelstahl und einem anderen Metall kann das Gehäuse 2 auch aus anderen Metallen, beispielsweise Aluminium, bestehen, das sich auf der Frontseite 4 eloxieren läßt und dadurch sehr widerstandsfähig gegen Korrosion wird.

## Patentansprüche

1. Piezoelektrischer Taster (1 ) mit einem Gehäuse (2 ), das einen Sitz (13) für ein piezokeramisches Element (24) aufweist, sowie mit einem von außen willkürlich bewegbaren Betätigungsorgan (31), das zur Einwirkung auf das piezokeramische Element (24) bringbar ist, dadurch gekennzeichnet, daß das Gehäuse (2) an seiner Frontseite (4) eine Öffnung (8) aufweist, in die im Abstand von der Frontseite (4) Vorsprünge (7) ragen, daß das Betätigungsorgan von einer stabilen, in der Öffnung (8) angeordneten Betätigungsplatte (29) gebildet ist, die eine Rückseite (32) sowie eine nach außen gekehrte Vorderseite (31) aufweist und für die die Vorsprünge (9 ) einen Anschlag bilden, der die Bewegung der Betätigungsplatte (29) in das Gehäuse (2) hinein begrenzt, daß der Sitz (13) für das piezokeramische Element (24) der Rückseite (32) gegenüberliegend angeordnet ist und daß wenigstens einer Seite des piezokeramischen Elementes (24) ein nachgiebiges Ausgleichsstück (17) zugeordnet ist.

2. Piezoelektrischer Taster (1) mit einem Gehäuse (2), das einen Sitz (13) für ein piezokeramisches Element (24) aufweist, sowie mit einem von außen willkürlich bewegbaren Betätigungsorgan (31), das zur Einwirkung auf das piezokeramische Element (24) bringbar ist, dadurch gekennzeichnet daß das Gehäuse (2) an seiner Frontseite (4) einen Wandbereich, der das Betätigungsorgan (29) bildet, und eine Rückseite (32) aufweist, mit der das piezokeramische Element (24) stoffschlüssig verbunden ist.

3. Piezoelektrischer Taster nach Anspruch 1 oder 2, dadurch gekennzeichnet, daß das piezokeramische Element (24) von einer piezoelektrisch wirkenden Keramikscheibe (25) sowie einer mit der Keramikscheibe (25) stoffschlüssig verbundenen Metallscheibe (26) gebildet ist, die randseitig über die Keramikscheibe (25) übersteht.

4. Piezoelektrischer Taster nach Anspruch 1 oder 2, dadurch gekennzeichnet, daß das piezokeramische Element (24) die Gestalt einer runden Kreisscheibe aufweist.

5. Piezoelektrischer Taster nach Anspruch 1, dadurch gekennzeichnet, daß ein eine große Mittenöffnung (28) enthaltendes ringförmiges Distanzstück (27) vorgesehen ist, das der einen Seite des scheibenförmig gestalteten piezokeramischen Elementes (24) zugeordnet ist.

6. Piezoelektrischer Taster nach den Ansprüchen 4 und 5, dadurch gekennzeichnet, daß die Mittenöffnung (28) kreisförmig ist und daß ihr Durchmesser gleich dem Durchmesser der piezoelektrisch wirksamen Keramikscheibe (25) ist.

7. Piezoelektrischer Taster nach Anspruch 5, dadurch gekennzeichnet, daß das Distanzstück (27) stoffschlüssig mit dem piezokeramischen Element (24) verbunden sind.

8. Piezoelektrischer Taster nach Anspruch 5, dadurch gekennzeichnet, daß das Distanzstück (27) aus Kunststoff besteht und mit dem piezokeramischen Element (24) verklebt ist.

9. Piezoelektrischer Taster nach Anspruch 5, dadurch gekennzeichnet, daß das piezokeramische Element (24) mit dem ringförmigen Distanzstück (27) unmittelbar mit dem Sitz (13) oder der Rückseite (32) der Betätigungsplatte (29) verbunden ist.

10. Piezoelektrischer Taster nach den Ansprüchen 5 und 8, dadurch gekennzeichnet, daß das nachgiebige Ausgleichsstück (17) gegenüber der Seite des piezokeramischen Elementes (24) angeordnet ist, die nicht das ringförmige Distanzstück (27) trägt.

11. Piezoelektrischer Taster nach Anspruch 1, dadurch gekennzeichnet, daß das Ausgleichsstück (17) die Gestalt einer Lochscheibe hat.

12. Piezoelektrischer Taster nach Anspruch 1, dadurch gekennzeichnet, daß das Ausgleichsstück (17) aus Gummi besteht.

13. Piezoelektrischer Taster nach Anspruch 1, dadurch gekennzeichnet, daß der Sitz von einer im wesentlichen planen Fläche (13) gebildet ist, die in dem Gehäuse (2 ) im Abstand und parallel zu einer Ebene verläuft, die durch die Frontseite (4 ) des Gehäuses (2 ) definiert ist.

14. Piezoelektrischer Taster nach Anspruch 1, dadurch gekennzeichnet, daß die Vorsprünge von einer Ringschulter (9 ) gebildet sind.

15. Piezoelektrischer Taster nach Anspruch 1, dadurch gekennzeichnet, daß der Abstand der Vorsprünge (9) von der Frontseite (4) um den Hub der Betätigungsplatte (29) größer ist als die Dicke der Betätigungsplatte (29).

16. Piezoelektrischer Taster nach Anspruch 1, dadurch gekennzeichnet, daß bei dem Betätigungsplatte (29) die Vorder- und die Rückseite (31, 32) parallel zueinander verlaufen.

17. Piezoelektrischer Taster nach Anspruch 1, dadurch gekennzeichnet, daß die Betätigungsplatte (29) der Öffnung (8 ) seitliches Spiel aufweist.

18. Piezoelektrischer Taster nach Anspruch 5, dadurch gekennzeichnet, daß der Sitz (13), das Ausgleichsstück (17), das Distanzstück (27), das piezokeramische Element (24) und die Rückseite (32) der Betätigungsplatte (29) an den Flächen, an denen sie miteinander in Berührung stehen, stoffschlüssig miteinander verbunden sind.

19. Piezoelektrischer Taster nach Anspruch 1, dadurch gekennzeichnet, daß die Vorderseite (31) der Betätigungsplatte (29) eben und im Ruhezustand mit der Frontseite (4) des Gehäuses (2) bündig ist.

20. Piezoelektrischer Taster nach Anspruch 1, dadurch gekennzeichnet, daß das piezokeramische Element (24) vollflächig mit der Rückseite (32) stoffschlüssig verbunden ist.

21. Piezoelektrischer Taster nach Anspruch 2, dadurch gekennzeichnet, daß der das Betätigungsorgan (29) bildende Wandbereich mit dem Gehäuse (2) einstückig ist.

22. Piezoelektrischer Taster nach Anspruch 2, dadurch gekennzeichnet, daß das Gehäuse (2) mehrere, räumlich voneinander getrennte Wandbereiche aufweist, die unterschiedliche Betätigungsorgane (29) für mehrere piezokeramische Elemente (24) bilden, und daß jedem Betätigungsorgan (29) ein piezokeramisches Element (24) zugeordnet ist.

23. Piezoelektrischer Taster nach Anspruch 2, dadurch gekennzeichnet, daß die Frontseite (4) aus Metall besteht.

24. Piezoelektrischer Taster nach Anspruch 23, dadurch gekennzeichnet, daß das Metall Aluminium ist.

25. Piezoelektrischer Taster nach Anspruch 23, dadurch gekennzeichnet, daß das Metall Edelstahl ist.
